# EUROPÄISCHE PATENTSCHRIFT

(11) **EP 1 584 942 B1**
(45) Veröffentlichungstag und Bekanntmachung des Hinweises auf die Patenterteilung: **14.05.2008**
(21) Anmeldenummer: 05101879.4
(22) Anmeldetag: 10.03.2005
(51) Int. Cl.: G01R 33/54

(54) **Verfahren zur Ermittlung und Darstellung für einen Betrieb eines Geräts notwendiger Justageschritte**
Method of determining and displaying steps of adjustment necessary for running an apparatus
Méthode de détermination et d'affichage de pas nécessaires pour le fonctionnement d'un appareil

(30) Priorität: 19.03.2004 DE 102004013614
(43) Veröffentlichungstag der Anmeldung: 12.10.2005
(73) Patentinhaber: SIEMENS AKTIENGESELLSCHAFT, 80333 München (DE)
(72) Erfinder: Campagna, Dr. Swen, 91238 Engelthal (DE)

(56) Entgegenhaltungen:
- EP-A- 1 004 891
- WO-A-97/15840
- WO-A-03/021284
- US-B1- 6 690 961

## Beschreibung

Die vorliegende Erfindung betrifft ein Verfahren zur Ermittlung und Darstellung für einen Betrieb eines Geräts notwendiger Justageschritte.

Viele Geräte erfordern vor ihrem Betrieb eine Durchführung von Justagen. Dies ist insbesondere bei bildgebenden Diagnosegeräten der Fall. So ist beispielsweise vor einer Untersuchung mittels eines Magnetresonanzgerätes eine Justage erforderlich, um es auf einen jeweiligen Betriebsmodus abzustimmen. Im Allgemeinen ist dabei eine Vielzahl verschiedener Justageschritte erforderlich, die vom Diagnosegerät automatisch durchgeführt werden können. Für spezielle Betriebsmodi, beispielsweise Service, Forschung oder Spektroskopie, ist es jedoch wünschenswert, dass ein jeweiliger Anwender die Justageschritte auch manuell durchführen zu kann. Dabei kann es durch ein komplexes Zusammenspiel der zahlreichen verschiedenen Justageschritte zu Fehljustagen kommen, die das Diagnosegerät durch nochmalige automatische Durchführung der notwendigen Justageschritte ausgleicht. Beispielsweise ist nach einer so genannten Shim-Justage eines Magnetresonanzgeräts, bei der Magnetfeldinhomogenitäten ausgeglichen werden, häufig eine Justage der Resonanzfrequenz erforderlich, auch wenn diese schon vor der Shim-Justage erfolgt ist. Übersieht der Anwender in diesem Fall die Notwendigkeit der erneuten Justage der Resonanzfrequenz, führt das Magnetresonanzgerät vor einer Messung die notwendigen Justageschritte automatisch durch. Dies ist zeitaufwändig und erzielt unter Umständen nicht das vom Anwender gewünschte Ziel einer, insbesondere zu Testzwecken angepassten Justage.

In gedruckten Bedienungsanleitungen für Geräte sind im Allgemeinen auch Justageschritte erläutert. Als Beispiel wird auf die Bedienungsanleitung des LCD-Farbmonitors "FlexScan^{®}" L367 der Firma Eizo (2002, Seiten 22 bis 28) verwiesen. In dieser Bedienungsanleitung sind mögliche Justageschritte nacheinander aufgeführt und erläutert. So wird einem Benutzer ermöglicht, die Justage des Farbmonitors selbst durchzuführen. Für derart einfache Justagen ist eine gedruckte Bedienungsanleitung zufrieden stellend. Im oben beschriebenen Fall des Magnetresonanzgeräts wäre eine Justage anhand einer gedruckten Bedienungsanleitung allerdings sehr aufwändig, da die Anzahl von möglichen Justageschritten im Vergleich zum Farbmonitor deutlich höher ist und zwischen den einzelnen Justageschritten die bereits beschriebenen Abhängigkeiten bestehen

Die WO 03/021284 A1 beschreibt ein Verfahren und ein System zur Optimierung von Messparametern für Magnetresonanzgeräte. Dabei werden insbesondere Abhängigkeiten zwischen Messparametern berücksichtigt und so verhindert, dass ein Benutzer ungültige Messparameter eingeben kann. Dabei wird in dem beschriebenen Verfahren nach Änderung eines Messparameters durch den Benutzer automatisch kontrolliert, ob dieser Parameter weiterhin in einem zulässigen Bereich liegt und welche Auswirkungen auf andere Parameter entstehen. Falls es hier zu Konflikten kommt, wird der Benutzer zur Behebung aufgefordert.

Die Aufgabe der vorliegenden Erfindung besteht darin, ein Verfahren anzugeben, dass die manuelle Justage für den Anwender einfach durchführbar macht und eine Fehljustage weitestgehend vermeidet.

Diese Aufgabe wird durch das Verfahren nach Anspruch 1 gelöst. Eine Notwendigkeit zur Durchführung von Justageschritten kann durch eine Vielzahl von Umständen entstehen. Beispielsweise ist es möglich, dass während einer Untersuchung mittels eines Magnetresonanzgeräts verschiedene Untersuchungsmethoden zum Einsatz kommen, die unterschiedliche Betriebsparameter erfordern. So könnten an mehreren Positionen des Patienten Untersuchungen durchgeführt werden, unter Umständen mit verschiedenen Empfangsspulen. In diesem Fall wäre eine erneute Justage des Magnetresonanzgeräts erforderlich. Ebenfalls ist es wie bereits erwähnt möglich, dass bei speziellen Betriebsmodi, wie Spektroskopie oder Service, besondere Einstellungen erforderlich sind. Hier ist es insbesondere wichtig, die manuelle Durchführung der Justageschritte zu erleichtern. Durch eine Darstellung einer Liste der für einen Betrieb, beispielsweise einen speziellen Diagnosemodus, notwendigen Justageschritte und dazugehörender Justagemöglichkeiten auf einem Anzeigemedium kann ein Anwender auf einfache Weise den jeweils durchzuführenden Justageschritt auswählen und die zugehörige Justagemöglichkeit ausführen. Die Ermittlung und Darstellung einer Reihenfolge der durchzuführenden Justageschritte leitet den Anwender durch den Justageprozess, gibt ihm aber gleichzeitig eine Möglichkeit einen anderen, als den vorgesehenen Justageschritt durchzuführen. Insbesondere bei Magnetresonanzgeräten gibt es für einige Justageschritte mehrere Justagemöglichkeiten. So ist eine Shim-Justage beispielsweise durch einen 3D-Shim oder einen interaktiven Shim durchführbar. Im diesem Fall erscheinen die entsprechenden Justagemöglichkeiten an gleicher Stelle in der Reihenfolge, beispielsweise beide mit der Nummer "Zwei". Dies zeigt dem Anwender bei Betrachten der Liste unmittelbar an, welche Justagemöglichkeiten er für den jeweiligen Justageschritt hat. Nach jeder Durchführung eines der Justageschritte wird eine aktualisierte Liste von noch durchzuführenden Justageschritten erzeugt. Ebenfalls wird die Reihenfolge der Justageschritte erneut bestimmt und beides auf dem Anzeigemedium dargestellt. Dies trägt dem komplexen Zusammenspiel der verschiedenen Justageschritte Rechnung und vermindert signifikant die Fehleranfälligkeit der manuellen Durchführung von Justagen. Wie bereits erläutert wurde, kann es nach Durchführung eines Justageschritts notwendig sein, einen bereits durchgeführten Justageschritt zu wiederholen.

In einem vorteilhaft ausgeführten Verfahren werden bei der Durchführung eines Justageschritts ermittelte Justageparameter in einer Datenbank gespeichert. Dadurch ist ein Status jedes Justageschritts verfügbar, der bei der Erzeugung der Liste berücksichtigt werden kann. Zusätzlich wird nach Erzeugen der Liste die Datenbank abgefragt, die den Status jedes möglichen Justageschritts vorhält. Dadurch können Justageschritte, die bereits erfolgreich ausgeführt wurden, beispielsweise bei einem vorherigen Betrieb, bei der durchzuführenden Justage ausgelassen werden. In der erzeugten Liste sind die entsprechenden Justageschritte als bereits durchgeführt gekennzeichnet.

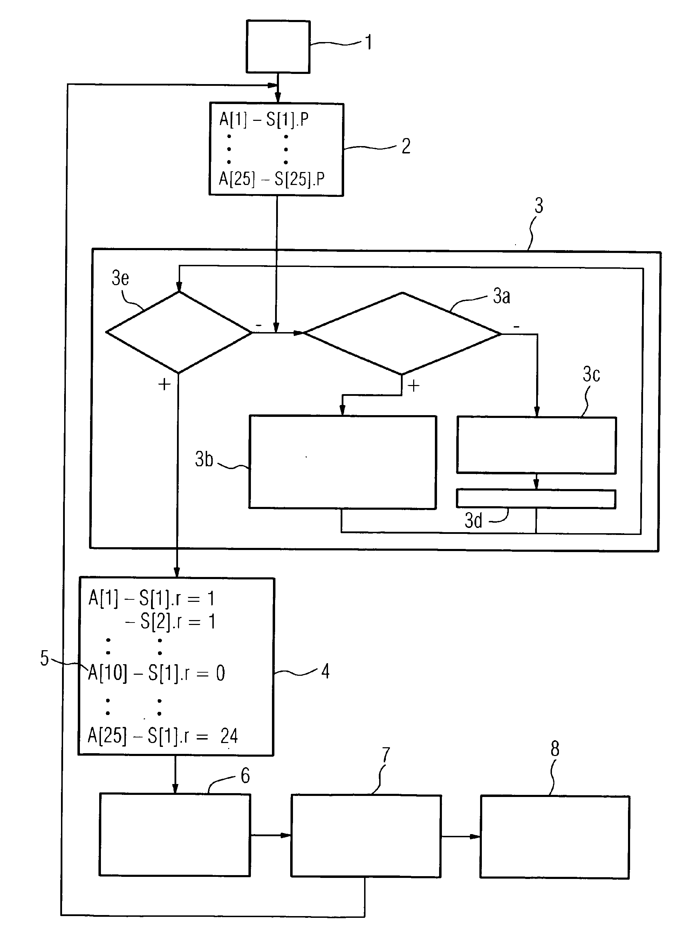

Weitere Vorteile und Einzelheiten ergeben sich aus der nachfolgenden Beschreibung eines Ausführungsbeispiels in Verbindung mit der Zeichnung.

Gemäß der Figur wird ausgehend von der Wahl eines spezifischen Betriebsmodus 1 in einem Schritt 2 eine Liste aller für den jeweiligen Betriebsmodus notwendigen Justageschritte A[i] generiert. Die Variable i dient dabei zur Nummerierung der einzelnen Justageschritte A[i], bei der schematisch angedeuteten Liste wäre i∈{1,...,25}. Für die Durchführung eines Justageschritts A[i] kommen eventuell mehrere Justagemöglichkeiten S[j] in Betracht, die alternativ ausgeführt werden können. Der Parameter j dient wiederum zur Nummerierung der alternativen Justagemöglichkeiten S[j] für einen Justageschritt A[i]. Wie bereits erläutert wurde, ist beispielsweise beim Justageschritt "Shim-Justage" eines Magnetresonanzgeräts sowohl ein 3D-Shim (bspw. S[1]) als auch ein interaktiver Shim (bspw. S[2]) zum Ausgleich von Magnetfeldinhomogenitäten möglich. Die generierte Liste enthält eine Kennzeichnung der Justageschritte A[i], die bereits erfolgreich ausgeführt wurden und keine erneute Ausführung benötigen. Dies wird durch eine hier nicht dargestellte Abfrage einer Datenbank erreicht, die den Status der Justageschritte A[i] vorhält. Auch die bei der, unter Verwendung einer Justagemöglichkeit S[j] bereits erfolgten Durchführung des jeweiligen Justageschritts A[i] verwendeten Justageparameter S[j].P, also beispielweise Einstellungen für Shim-Spulen, sind in der Datenbank vorgehalten und werden in der erzeugten Liste dem jeweiligen Justageschritt A[i] zugeordnet.

In einem Schritt 3 wird in einer Schleife für alle Justageschritte A[i] der Liste in einem Schritt 3a überprüft, ob sie bereits durchgeführt wurden. Ist dies der Fall, werden in einem Schritt 3b alle Justagemöglichkeiten S[j], die für eine Ausführung des jeweiligen Justageschritt A[i] in Frage kommen als nicht erforderlich gekennzeichnet und ihnen die entsprechenden Justageparameter S[j].P zugeordnet. Gleichzeitig wird ein der jeweiligen Justagemöglichkeit S[j] zugeordneter Reihenfolgenparameter S[j].r auf den Wert "Null" gesetzt. Für den Fall, dass der Justageschritt A[i] noch nicht durchgeführt wurde oder erneut auszuführen ist, werden in einem Schritt 3c alle in Frage kommenden Justagemöglichkeiten S[j] als erforderlich gekennzeichnet. Außerdem wird jeder Justagemöglichkeit S[j] ein Reihenfolgenparameter S[j].r zugeordnet, der für alternative Justagemöglichkeiten S[j] einen gleichen Wert hat. Hiernach wird in einem Schritt 3d der Reihenfolgenparameter S[j].r um den Wert "Eins" erhöht. In einem Schritt 3e wird überprüft, ob bereits alle Justageschritte A[i] der Liste abgearbeitet wurden. Falls dies zutrifft wird die Schleife beendet. Andernfalls wird mit dem nächsten Justageschritt A[i+1] der Liste fortgefahren. So erhält jeder Justageschritt A[i] der Liste einen Reihenfolgenparameter S[j].r zugeordnet, anhand dem die Reihenfolge der verschiedenen Justageschritte A[i] festgelegt ist. Außerdem erhalten alternative Justagemöglichkeiten S[j] eines Justageschritts A[i] denselben Reihenfolgenparameter S[j].r. Nicht durchzuführende Justageschritte A[i] treten in der Reihenfolge nicht auf, da ihr zugeordneter Reihenfolgenparameter S[j].r den Wert "Null" aufweist.

Nachdem alle Justageschritte A[i] der Liste innerhalb der Schleife überprüft wurden, wird in einem Schritt 4 eine, hier schematisch gezeigte Liste 5 aller Justagemöglichkeiten S[j] erzeugt, die zum gewählten Betriebsmodus gehören. In einem Schritt 6 wird die Liste 5 in einer für den Anwender verwendbaren Form, beispielweise direkt mit einer Möglichkeit zur Durchführung und Einstellung der Justageparameter S[j].P, auf einem Anzeigemedium dargestellt und den Reihenfolgenparameter S[j].r entsprechend in der Reihenfolge gekennzeichnet. Die Justagemöglichkeiten S[j], bei denen der Reihenfolgenparameter S[j].r auf "Null" gesetzt ist, sind bereits ausgeführt und dementsprechend gekennzeichnet. Der Anwender hat so die Möglichkeit, einfach zu erkennen, welche Justagemöglichkeit S[j] als nächstes ausgeführt werden muss und welche Alternativen ihm geboten sind. Er hat außerdem die Möglichkeit eine bereits ausgeführte Justagemöglichkeit S[j] erneut auszuführen, um eine andere Einstellung vorzunehmen. Nach der Ausführung einer Justagemöglichkeit S[j] in Schritt 7 werden die während der Ausführung der Justagemöglichkeit S[j] gewählten Justageparameter S[j].P in einem Schritt 8 in der Datenbank gespeichert. Gleichzeitig beginnt das Verfahren wieder mit der Erstellung einer Liste notwendiger Justageschritte A[i] in Schritt 2, da die verschiedenen Justagemöglichkeiten S[j] durch ihr komplexes Zusammenspiel nach ihrer Ausführung andere Justageschritte A[i] erforderlich machen können. Dabei werden für die Erzeugung der neuen Liste die aktualisierten Werte für die jeweiligen Justageschritte A[i] aus der Datenbank abgefragt.

## Patentansprüche

1. Verfahren zur Ermittlung und Darstellung für einen Betrieb eines Geräts notwendiger Justageschritte, bestehend aus folgenden Verfahrensschritten:
- Erzeugen einer Liste mit für den Betrieb des Geräts notwendigen Justageschritten,
- Darstellung der verschiedenen Justageschritte auf einem Anzeigemedium,
**dadurch gekennzeichnet, dass**
- eine Reihenfolge für die notwendigen Justageschritte ermittelt wird, wobei alternative Justagemöglichkeiten eines Justageschrittes in der Reihenfolge entsprechend **gekennzeichnet** sind,
- bei der Darstellung der verschiedenen Justageschritte auf dem Anzeigemedium die Reihenfolge gleichzeitig markiert dargestellt wird und
- nach Durchführung eines der Justageschritte eine aktualisierte Liste mit notwendigen Justageschritten erzeugt und eine Reihenfolge der notwendigen Justageschritte ermittelt und auf dem Anzeigemedium dargestellt werden.

2. Verfahren nach Anspruch 1,
- bei dem nach Durchführung eines Justageschritts mindestens ein ermittelter Justageparameter in einer Datenbank gespeichert wird und
- nach Erzeugen der Liste mit den notwendigen Justageschritten aus der Datenbank abgefragt wird, ob die Justageschritte bereits durchgeführt wurden und eine erneute Durchführung notwendig ist.

3. Verfahren nach Anspruch 2, bei dem lediglich für die noch durchzuführenden Justageschritte eine Reihenfolge ermittelt wird und auf dem Anzeigemedium dargestellt wird.

4. Verfahren nach einem der obigen Ansprüche, bei dem ein Anwender einen Betriebsmodus auswählt.

## Claims

1. A method for determining and representing adjustment steps for an apparatus requiring adjustment, consisting of the following method steps:
- generating a list of adjustment steps necessary for operation of the apparatus,
- visually representing said adjustment steps on a display medium
**characterised in that**
- a sequence for the necessary adjustment steps is determined, with alternative adjustment options of an adjustment step being identified accordingly in said sequence,
- in the representation of the different adjustment steps on the display medium the sequence is shown simultaneously marked, and
- after execution of one of the adjustment steps an updated list with necessary adjustment steps is created and a sequence of the necessary adjustment steps is determined and represented on the display medium.

2. Method according to claim 1,
- in which at least one adjustment parameter determined is stored in a database after execution of an adjustment step and
- after generation of the list with the necessary adjustment steps, the database is queried as to whether the adjustment steps have already been executed and whether a new execution is necessary.

3. Method according to claim 2, in which a sequence is only determined for the adjustment steps still to be executed and said sequence is represented on a display medium.

4. Method according to one of the above claims, in which a user selects an operating mode.

## Revendications

1. Procédé de détermination et de représentation d'étapes de réglage nécessaires au fonctionnement d'un appareil, ledit procédé comprenant les étapes suivantes consistant à :
- générer une liste d'étapes de réglage nécessaires au fonctionnement de l'appareil,
- représenter les différentes étapes de réglage sur un support de présentation,
**caractérisé en ce que**
- on détermine un ordre des étapes de réglage nécessaires, des variantes possibles de réglage d'une étape de réglage étant **caractérisées** de façon appropriée dans l'ordre,
- lors de la représentation des différentes étapes de réglage sur le support de présentation, l'ordre est représenté tout en étant marqué et
- après avoir représenté l'une des étapes de réglage, on génère une liste actualisée d'étapes de réglage nécessaire et on détermine un ordre des étapes de réglage nécessaires et on le représente sur le support de présentation.

2. Procédé selon la revendication 1, dans lequel
- après avoir réalisé une étape de réglage, on mémorise un paramètre de réglage déterminé dans une base de données et
- après avoir généré la liste d'étapes de réglage, on interroge la base de données pour savoir si les étapes de réglage ont déjà été réalisées et si une nouvelle réalisation est nécessaire.

3. Procédé selon la revendication 2, dans lequel on détermine un ordre seulement pour les étapes de réglage qui restent à réaliser et on le représente sur le support de présentation.

4. Procédé selon l'une des revendications précédentes, dans lequel un utilisateur choisit un mode de fonctionnement.
